# EUROPEAN PATENT APPLICATION

(11) **EP 1 975 505 A1**
(43) Date of publication of application: **01.10.2008**
(21) Application number: 07104906.8
(22) Date of filing: 26.03.2007
(51) Int. Cl.: F21V 29/02

(54) **Lighting device**

(71) Applicant: Koninklijke Philips Electronics N.V., 5621 BA Eindhoven (NL)
(72) Inventor: The designation of the inventor has not yet been filed
(74) Representative: Pet, Robert Jacob

(57) **Abstract**

The invention relates to a lighting device comprising a light source, the light source being mounted on a heat sink, the heat sink having an outer contour. Further it comprises a cooling device for providing dynamic cooling of the light source via cooling of the heat sink by means of a fluid flowing alongside the contour of the heat sink, the cooling device having one or a plurality of cooling openings. The cooling device is a vibrating membrane cooling system for generating a sequence of fluid pulses. The cooling openings are arranged alongside the heat sink. The light source comprises optical means for collimating and directing light originating from the light source during operation, the contour of the heat sink having a similar shape as a contour of the optical means.

## Description

### FIELD OF THE INVENTION

The invention relates to a lighting device.

### BACKGROUND OF THE INVENTION

Such a lighting device is known from GB2420172A. The known lighting device comprises a light source, the light source being mounted on a heat sink. The heat sink has a contour. It furthermore has a cooling device which is an electric fan for providing dynamic cooling of the light source via cooling of the heat sink by means of a gas flow. It is a disadvantage of the known lighting device that the use of the fan used for cooling has a number of limitations. For example, much of the circulated gas, for example air, bypasses the heat sink and does not mix well with the thermal boundary layer that is formed on cooling fins of the heat sink. A fan placed directly opposite or over said heat sinks have "dead areas" where its motor assemblies block airflow, causing for example turbulent gas flow. Furthermore, a fan uses relatively much energy, creates audible noise and takes up relatively much space.

### SUMMARY OF THE INVENTION

It is an object of the invention to provide a lighting device of the type as described in the opening paragraph in which the disadvantage is counteracted. Thereto the lighting device is characterized in that the lighting device comprises
at least one light source, the light source being mounted on a heat sink, the heat sink having a contour,
a cooling device for providing dynamic cooling of the light source via cooling of the heat sink by means of a fluid flowing alongside the heat sink, the cooling device having at least one cooling opening,
the cooling device is a vibrating membrane cooling system for generating a sequence of fluid pulses.

Experiments have shown that a significant more effective cooling is obtained compared to conventional cooling with an electric fan. In practice, the vibrating membrane cooling system appeared to produce two to three times more cooling with two-thirds less energy input than with a conventional fan. The system is even more efficient when the vibrating membrane cooling system is embodied as a resonance cooling system. The vibrating membrane cooling system appeared to be simple and with no friction parts to wear out, the synthetic jet module (= vibrating membrane cooling system) resembles a tiny stereo speaker in which a diaphragm is mounted within a cavity (=vibrating membrane chamber) that has one or more orifices (=cooling openings). The cooling system can comprise one or more synthetic jet modules and heat sinks which modules can be located above, below or next to the light source. The cooling system is usable for cooling both the light source and/or other parts of the lighting device, for example the driver means (=electronic circuit).

In an embodiment the lighting device is characterized in that at least one cooling opening numbers at least two and that said cooling openings are arranged alongside the contour of the heat sink. The cooling device thus creates a cooling pattern that is similarly shaped to the contour of the heat sink resulting in that the heat sink is flushed (in Dutch = omspoelt / wordt omspoeld ) with a fluid flow. In particular the contour of the heat sink, which can be an inner contour, an outer contour or both inner and outer contour, is for a major part, for example more than 50%, preferably more than 70% even more preferably more than 85% exposed to a fluid flow created by the cooling device as the more exposure the better the cooling. The fluid can be a gas or a liquid. In the case the fluid is a gas, the gas is preferably air. With four openings it is enabled to create a three-dimensional arrangement of the openings and thus to effectively cool three-dimensional heat sinks, for example by providing two cooling openings at its outer side flushing the outer contour and by providing two other cooling openings at the inner side of the heat sink flushing the inner contour. It is further enabled that if the contour is according to a curved surface/plane to substantially totally flush, for example the outer side of the heat sink with flowing fluid by the three dimensional arrangement of the cooling openings.

In a further embodiment the lighting device is characterized in that the light source comprises optical means for collimating and directing light originating from the light source during operation thus to have beam control, the contour of the heat sink having a similar shape as a contour of the optical means. It is thus realized that the heat sink consumes then relatively little space compared to known, conventional lighting devices comprising heat sinks. Despite the complex, three dimensional shape the heat sink thus may have, it appeared still possible to practically completely flush the heat sink with a fluid flow from the resonance cooling system, as it appeared possible to transport the fluid pulses. Thereto the lighting device is characterized in that cooling system has a vibrating membrane chamber connected to which each cooling opening is connected via a respective fluid pulse conductor. As long as the fluid pulse is within the fluid pulse conductor it is stable, meaning that no fluid is extracted/sucked from the environment and turbulence does not occur. Once the fluid pulse exits the cooling opening it influences the environmental atmosphere and extracts/sucks fluid from its direct surrounding resulting in the fluid pulse to become unstable and causing/becoming a turbulent fluid flow. Preferably the fluid pulse conductor has a length equal to N times halve a wavelength λ (lambda) of the fluid pulse sequence as generated by the vibrating membrane during operation, still further preferably in a resonating state. Then the vibrating membrane cooling system appeared to operate in the most efficient way, with relatively little energy losses.

From the experiments it was further concluded that in particular round tube shaped conductors are usable as fluid pulse conductor. Preferably a flexible tube is used as then an accurate, desired position of the cooling opening with respect to the heat sink could be easily obtained.

To further enhance the practically total flushing of the heat sink by fluid flow the lighting device is characterized in that at least one of the cooling openings is shaped as a showerhead. Flushing and hence cooling of the heat sink (and as a result thereof, cooling of the light source) is even further improved.

In another embodiment the lighting device is characterized in that the vibrating membrane chamber is provided at a distance from the light source, preferably at a distance which is at least three times a largest dimension of the heat sink. The possibility to transport the fluid pulse sequence over relatively large distances without significant energy losses enables to position the vibrating membrane chamber at a relatively large distance from the heat sink. As possibly still some noise may be generated by the vibrating membrane during operation of the lighting device, the possibility to transport the fluid pulse sequence enables to tuck away the vibrating membrane chamber, for example behind a false ceiling, the light source suspending from said ceiling via the fluid pulse conductor.

In a yet further embodiment the lighting device is characterized in that the lighting device is provided with a control circuit for controlling the cooling device. It is thus simply enabled to control/meet the changing thermal demands of the lighting device. Thereto the circuit may be provided with a sensor which detects the temperature of the heat sink, compares it to set values and submits steering signals to the cooling device. The cooling device may be designed such that it cools both the light source and the control circuit.

In a yet still further embodiment the lighting device is characterized in that the light source is at least one light emitting diode (LED). Lighting devices comprising LEDs are well known to suffer from heat management problems, in particular that cooling devices consumes relatively much space compared to the relatively small LEDs. The vibrating membrane cooling system is particularly suitable for cooling LEDs because of its compactness and high efficiency. The LEDs could have a white(W), red (R), green (G), blue (B) or amber (A) emission spectrum. By combination thereof, any desired light spectrum is obtainable that falls within the color space made up by the color coordinates of the WRGBA starting LEDs. The LEDs can be applied in combination with a secondary converting light-emitting element which is situated directly on the LEDs or are remote from the LEDs, for example remote phosphors or lumiramics.

In yet another embodiment the lighting device is characterized in that the heat sink is shaped as a number of annular cooling fins being arranged concentric around a heat sink axis and being spaced apart by annular slits. It is thus enabled to have an annular arrangement of small light sources, for example LEDs, to be mounted on one heat sink and yet still effectively cool each light source. In the case of a substantial annular arrangement of the light sources heat sinks having a round, triangular, rectangular, square, hexagonal, or octagonal shape in a plane perpendicular to the heat sink axis are in particular suitable. Alternatively it is possible to have a plurality of heat sinks to cool one or more arrangements of different light sources, of course in dependency of the amount of light sources involved, or still alternatively it is possible for one cooling system to cool a plurality of light sources. To enhance the cooling efficiency it is preferred if the cooling openings are positioned in or opposite respective slits of the heat sink(s). The lighting device of the invention can be used as a stand-alone unit or it may form part of a network comprising other electric devices.

### BRIEF DESCRIPTION OF THE DRAWINGS

The invention will now be further elucidated by means of the drawings, in which:
Fig. 1a-1b show a schematic view of cooling devices as used in prior art lighting devices;
Fig. 2 shows a schematic view of a cooling device as used in lighting devices according to the invention;
Fig. 3 shows a schematic view of a first embodiment of a lighting device according to the invention;
Fig. 4 shows a schematic view of a second embodiment of a lighting device according to the invention;
Fig. 5 shows a diagrammatic view of a third embodiment of a lighting device according to the invention;
Fig. 6 shows a side view of a fourth embodiment of a lighting device according to the invention;
Fig. 7 shows a perspective view of a plurality of lighting devices of Fig. 6;
Fig. 8 shows a bottom view of the lighting device of Fig. 7;
Figs. 9a-9c show a schematic representation of a single lighting device of Fig. 6 as well as some arrangements of a plurality of lighting devices of Fig. 6;
Fig. 10 shows design drawings of the lighting device of Fig. 6 (not to scale).

### DETAILED DESCRIPTION OF THE EMBODIMENTS

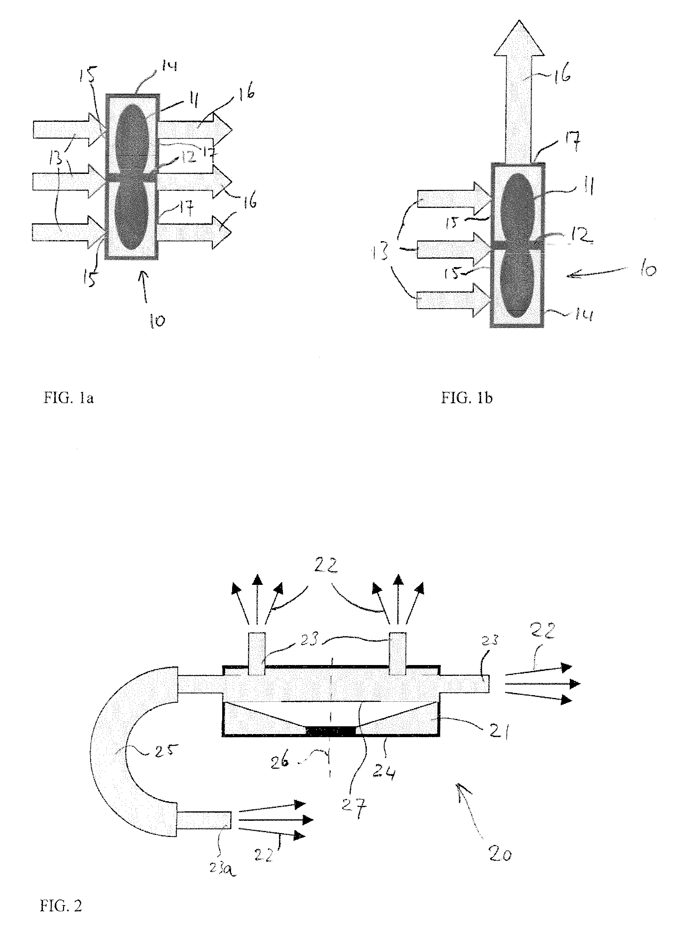

In Fig. 1a-b two basic shapes of an electric fan 10 as a cooling device are shown in a diagrammatic way. Each fan comprises a housing 14 and a propeller 11 rotating in said housing around a fan axis 12. In operation an airflow is created, an inward flow 13 enters the housing through an inlet opening 15 and exits the housing as an outward flow 16 through an outlet or cooling opening 17. In Fig. 1a the inlet and outlet opening are positioned opposite each other resulting in an axial airflow. In Fig. 1b, the inlet and outlet opening are positioned under an angle of 90° with respect to each other, the inlet flow being along the fan axis, the outlet flow being perpendicular to the fan axis 12. In practice it appeared that the fan operates very inefficient when outlet openings are provided in more than one direction.

In Fig. 2 a vibrating membrane cooling device 20 is shown diagrammatically. The vibrating membrane cooling device comprises a chamber 21 with a wall 24. The chamber is provided with a membrane 27 which vibrates, preferably resonates, along a vibration axis 26, and creates a sequence of fluid pulses 22 during operation, which pulses exit the chamber through cooling openings or orifices 23 provided in the wall 24. As shown, some orifices are provided practically in the wall 24 itself, other orifices for example 23a, are provided at some distance from the wall 24 and connected to the chamber via a tube-shaped pulse conductor 25. It does not matter for the efficiency of the vibrating membrane cooling device whether the openings are provided on one side of the chamber or on various sides and having various orientations with respect to the vibration axis.

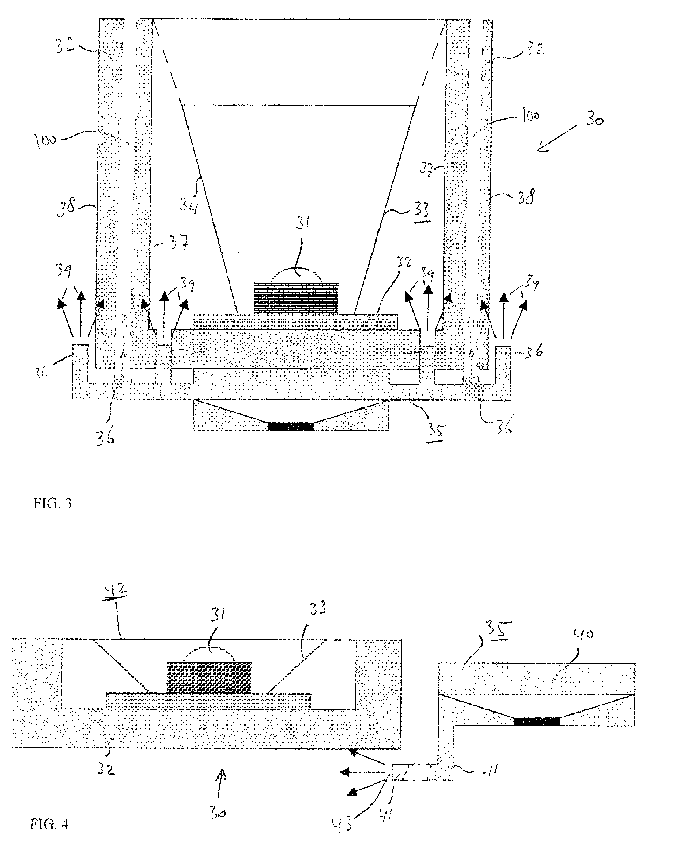

Fig. 3 shows a schematic view of a first embodiment of a lighting device 30 according to the invention. The lighting device comprises a light source 31, in the Fig. a compact high pressure mercury discharge lamp, for example a UHP lamp. The light source is mounted on a heat sink 32 and further comprises optical means 33, in the Fig. a parabolic reflector 33. The heat sink substantially has a similar shape as an outer contour 34 of the reflector. Adjacent the heat sink a vibrating membrane cooling device 35, in the Fig. a resonant cooling system, analogous to the one shown in Fig. 2 is provided. The device 35 has six orifices 36 that flush the heat sink with a sequence of fluid pulses 39 which, once out of the orifice, become turbulent fluid flow, both on its inner 37 and outer contour/side 38. Furthermore the heat sink comprises channels 100 into which via respective cooling openings 36 fluid pulses 39 are supplied. As a result of the overall cooling of the heat sink the light source is cooled very effectively.

Fig. 4 shows a schematic view of a second embodiment of a lighting device 30 according to the invention. In this embodiment the light source, in the Fig. a remote part 42 comprising a white LED 31, optical means 33 and heat sink 32 together are remote from a chamber 40 which forms part of the vibrating membrane cooling device 35. The fluid pulse sequence, in the Fig. the fluid is air, is generated in the chamber and transported via an air pulse conductor 41 to the heat sink which is effectively cooled thereby. In this embodiment the chamber has only one orifice 43. In an alternative arrangement (not shown), the remote part 42 is suspended via the air pulse conductor to a (false) ceiling and the chamber is tucked away in the ceiling or behind the false ceiling.

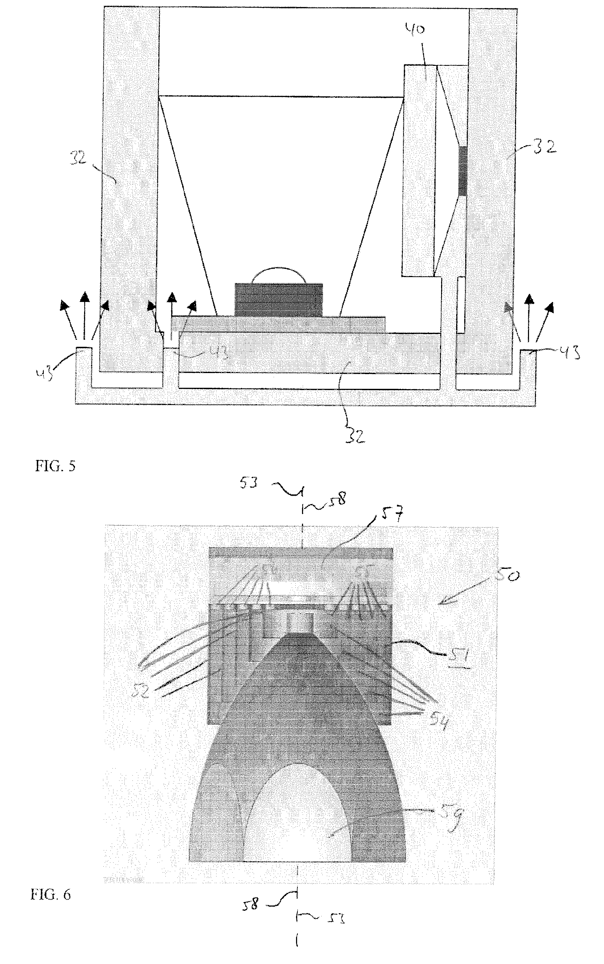

Fig. 5 shows a diagrammatic view of a third embodiment of a lighting device according to the invention in which the chamber 40 is positioned inside the heat sink 32. This renders the lighting device to have the advantage to consume even less space, while an aesthetic design of the lighting device is enabled as well. In this embodiment there are three orifices/cooling openings 43.

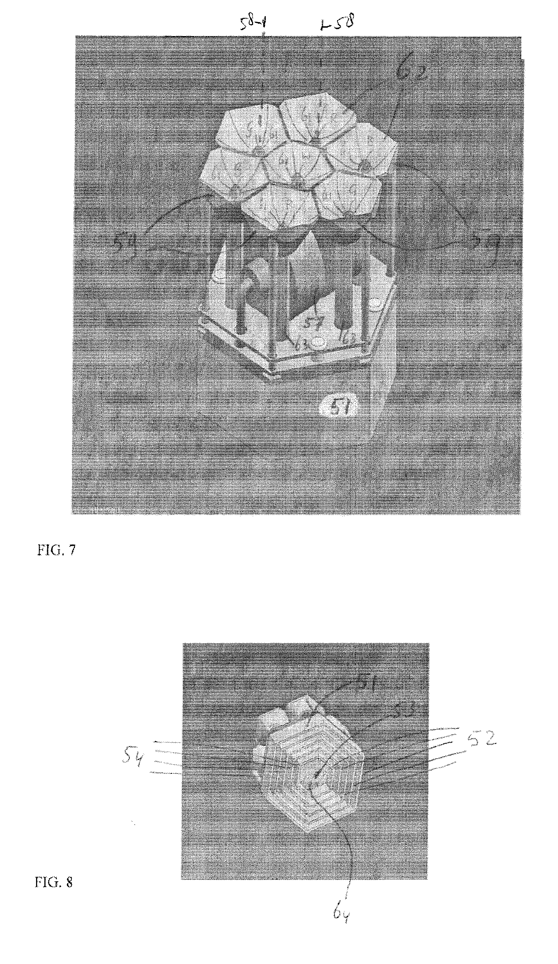

Fig. 6 diagrammatically shows a side view of a fourth embodiment of a lighting device 50 according to the invention. A heat sink 51 is provided which has a number of annular cooling fins 52 which are concentric around a heat sink axis 53 which in this embodiment coincides with an optical axis 58 of optic reflector 59 which collimates and directs light as emitted by the light source (see Fig. 7) during operation. Each pair of adjacent concentric fins is separated by respective slits 54. In a first end part 55 of each slit a respective orifice/cooling opening 56 of a resonance cooling device 57 is provided, the cooling openings together form a showerhead.

Fig. 7 shows a perspective view of a lighting system in which a total of seven of the lighting devices of Fig. 6. are comprised. Each lighting device has a respective light source 61 and each LED has a respective optic means 59 and is mounted via heat conducting pipes 63 on a respective heat sink 51. The heat sinks are cooled by a common resonance cooling device 57. The seven LEDs are arranged in a hexagon with six LEDs, i.e. two red R, two green G, and two blue B LEDs surrounding a central white LED W. Each reflector is widening along its respective optical axis 58 from its respective light source 61 towards its respective light emission window 62. On a side of the reflector facing away from the light emission window the resonance cooling device 57 is provided. The lighting system further comprises control means (see Fig.8) for controlling and meeting the demands of the cooling device.

Fig. 8 shows a bottom view of the lighting device of Fig. 7 in which the concentric annular hexagonal structured fins 52 of the heat sink 51 are clearly visible. The cooling fins are separated by slits 54. On the heat sink axis 53 and surrounded by the most central cooling fin 52 the control circuit 64 is provided.

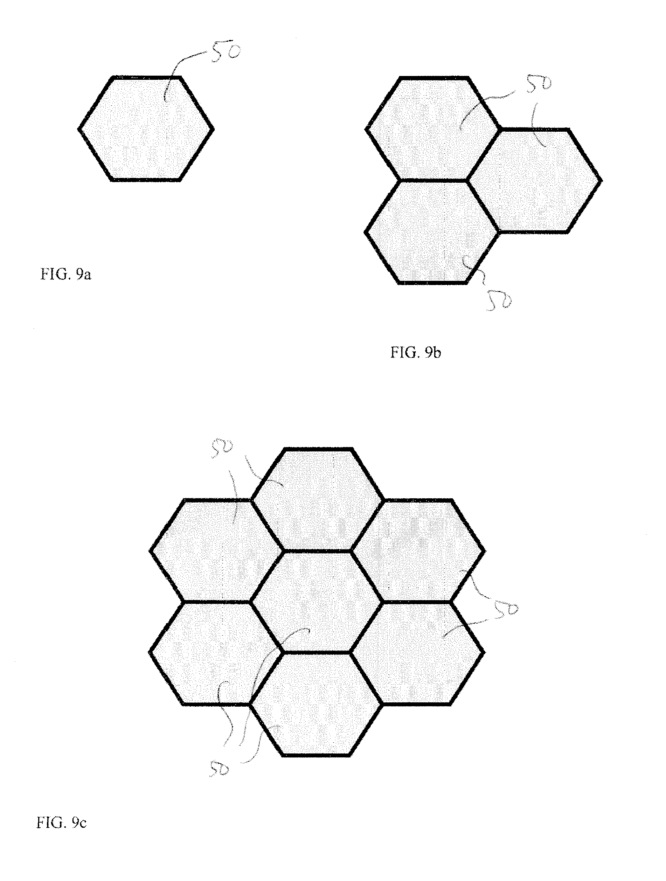

Fig. 9a-9c show in Fig. 9a a schematic representation of a single lighting device 50 of Fig. 6 and in Fig.9b respectively Fig. 9c respectively three and seven lighting devices arranged in a respectively trigonal and a hexagonal arrangement. The shown arrangements are just exemplary arrangements, many alternative arrangements, for example a chain-arrangement or a circle-arrangement (a hexagonal arrangement without the lighting device in the centre) are possible without deviating from the inventive concept.

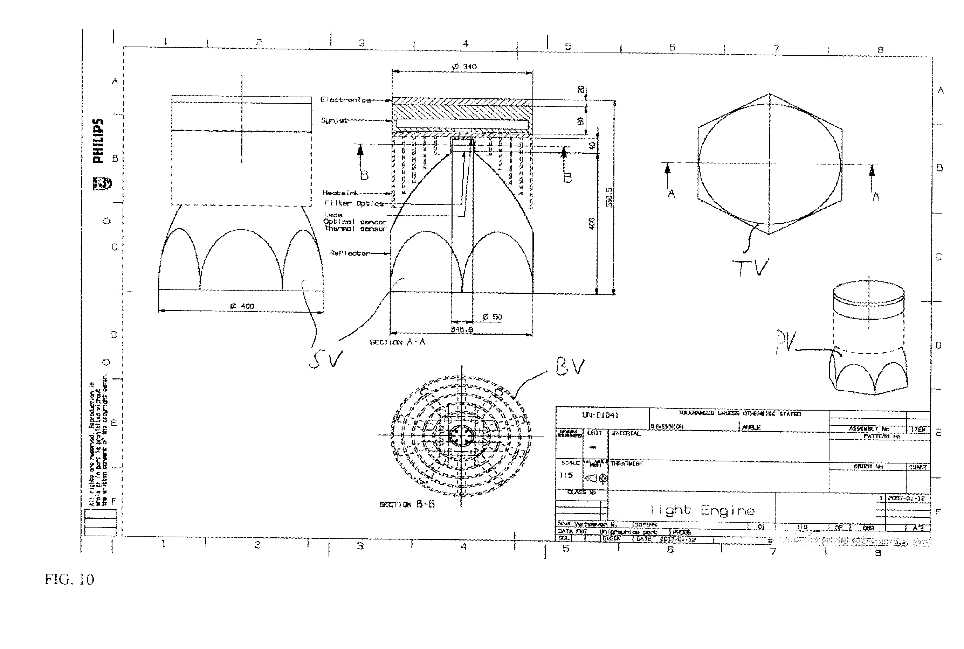

Fig. 10 shows design drawings of the lighting device of Fig. 6 (not to scale) in respectively a perspective view PV, a side view SV, top view TV and bottom view BV. The heat sink having cooling fins which are annular concentric rings.

## Claims

1. A lighting device **characterized in that** it comprises:
at least one light source, the light source being mounted on a heat sink, the heat sink having a contour;
a cooling device for providing dynamic cooling of the light source via cooling of the heat sink by means of a fluid flowing alongside the heat sink, the cooling device having at least one cooling opening;
the cooling device is a vibrating membrane cooling system for generating a sequence of fluid pulses.

2. A lighting device as claimed in claim 1, **characterized in that** at least one cooling opening numbers at least two, preferably at least four openings, and that said cooling openings are arranged alongside the contour of the heat sink.

3. A lighting device as claimed in claim 1, **characterized in that** the contour is according to a curved surface/plane.

4. A lighting device as claimed in claim 1, **characterized in that** the light source comprises optical means for collimating and directing light originating from the light source during operation, the contour of the heat sink having a similar shape as a contour of the optical means.

5. A lighting device as claimed in claim 1, **characterized in that** cooling system has a vibrating membrane chamber to which at least one cooling opening is connected via a respective fluid pulse conductor.

6. A lighting device as claimed in claim 5, **characterized in that** the fluid pulse conductor has a length equal to N times halve the wavelength λ (lambda) as generated by the resonator during operation.

7. A lighting device as claimed in claim 5, **characterized in that** the fluid pulse conductor is a tube, preferably a flexible tube.

8. A lighting device as claimed in claim 1, **characterized in that** at least one of the cooling openings is shaped as a showerhead.

9. A lighting device as claimed in claim 5, **characterized in that** the vibrating membrane chamber is provided at a distance from the light source, preferably at a distance which is at least three times, preferably at least seven times a largest dimension of the heat sink.

10. A lighting device as claimed in claim 1, **characterized in that** the lighting device is provided with a control circuit for controlling the cooling device.

11. A lighting device as claimed in claim 1, **characterized in that** the light source is at least one light emitting diode (LED).

12. A lighting device as claimed in claim 11, **characterized in that** a respective LED has a white, red, green, blue or amber emission spectrum, or any combination thereof.

13. A lighting device as claimed in claim 1, **characterized in that** the heat sink is shaped as a number of annular cooling fins being arranged concentric around a heat sink axis and being spaced apart by annular slits.

14. A lighting device as claimed in claim 13, **characterized in that** the heat sink has a round, triangular, rectangular, square, hexagonal, or octagonal shape in a plane perpendicular to the heat sink axis.

15. A lighting device as claimed in claim 13, **characterized in that** the cooling openings are positioned in or opposite respective slits of the heat sink.

16. A lighting device as claimed in claim 1, **characterized in that** the lighting device comprises a plurality of heat sinks.
